# EUROPEAN PATENT SPECIFICATION

(11) **EP 0 574 075 B1**
(45) Date of publication and mention of the grant of the patent: **07.02.1996**
(21) Application number: 93201576.1
(22) Date of filing: 02.06.1993
(51) Int. Cl.: C23C 16/54, C23C 16/44, H01L 21/00, C23C 16/50

(54) **Method of manufacturing a semiconductor device by means of a chemical vapour deposition**
Verfahren zur Herstellung eines Halbleiterbauelementes durch CVD
Procédé pour la fabrication d'un dispositif à semi-conducteur par CVD

(30) Priority: 09.06.1992 EP 92201655
(43) Date of publication of application: 15.12.1993
(73) Proprietor: Philips Electronics N.V., NL-5621 BA Eindhoven (NL)
(72) Inventor: Zijlstra, Piebe Anne, NL-5656 AA Eindhoven (NL)
(74) Representative: Rensen, Jan Geert

(56) References cited:
- US-A- 4 960 488
- PATENT ABSTRACTS OF JAPAN vol. 14, no. 205 (E-921)26 April 1990

## Description

The invention relates to a method of manufacturing a semiconductor device whereby a reaction chamber in which a layer of material is deposited on a semiconductor slice placed on a support in the reaction chamber, whereby a process gas is conducted towards the slice through a gas inlet system which is provided with a perforated gas inlet plate arranged opposite the support, between depositions is cleaned periodically through the generation of a plasma between the support and the gas inlet plate in a gas mixture comprising fluorine or a fluorine compound and oxygen or an oxygen compound.

During such a deposition process, for example, a layer of silicon, silicon oxide, silicon nitride, tungsten, or titanium nitride is deposited on the semiconductor slice. During this, the slice is heated to a temperature of 400 to 800° C in a chemical vapour deposition process, after which the process gas is conducted towards the slice. In the case of a plasma-enhanced chemical vapour deposition process, a plasma is generated between the support and the gas inlet plate. The said process gas then comprises a gaseous silicon compound, a gas mixture comprising a silicon compound and oxygen or an oxygen compound, a gas mixture comprising a silicon compound and nitrogen or a nitrogen compound, a tungsten compound, and a titanium compound, respectively. Usual silicon compounds are silane, dichlorosilane and tetraethoxysilane, while a usual oxygen compound is laughing gas and a usual nitrogen compound ammonia.

The process gas is conducted towards the slice placed on the support through a perforated gas inlet plate which is positioned opposite the support. The gas inlet plate is, for example, an aluminium plate in which a large number of holes with a diameter of, for example, 1 mm are provided, regularly distributed over its surface. The plate may also be manufactured from a porous material, such as sintered aluminium powder. Such a plate is perforated by means of channels which are present in the sintered material. The use of such a perforated gas inlet plate achieves that the process gas is homogeneously distributed over the slice, so that a homogeneous deposition is obtained. The gas inlet plate has a diameter which is at least equal to that of the slice.

A support for a single slice may be arranged in the process chamber, but alternatively there may be a support on which several slices may be arranged next to one another. In the former case, the chamber comprises a gas inlet system with a single gas inlet plate, in the latter case one with a comparatively large gas inlet plate or with several gas inlet plates.

During the deposition process a layer of material is deposited not only on the slice, but also on chamber components which are situated near the slice. When the deposition process is repeated, layers being deposited on subsequent slices, the layer on these chamber components increases in thickness. When the layer on the chamber components becomes too thick, particles may flake off from this layer and end up on the slice. These particles are undesirable there. Accordingly, the reaction chamber must be cleaned periodically.

An effective cleaning can be obtained when the reaction chamber is cleaned through generation of a plasma between the support and the gas inlet plate in a gas mixture comprising fluorine or a fluorine compound and oxygen or an oxygen compound which is conducted into the reaction chamber. Practical gas mixtures are, for example, a mixture of CF₄ and O₂, a mixture of SF₆ and N₂O, or a mixture of C₂F₆ and O₂, which exhibit a maximum cleaning effect when 10 to 30 vol. %, 30 to 50 vol. % and 40 to 60 vol. % O₂ are added to them, respectively. The materials mentioned above can be very effectively removed by means of such plasmas.

US-A-4,960,488 discloses a method of the kind mentioned in the opening paragraph whereby the gas mixture is conducted into the reaction chamber through the gas inlet plate.

It is found with the use of the known method that the chamber components close to the slice can be well cleaned. The known method, however, also has disadvantages. Thus the gas inlet plate is sometimes locally attacked by the cleaning process and sometimes undesirable particles still end up on the slices. Practically no particles arrive at the slices any more which contain the material which is deposited in the reaction chamber during the deposition process, but particles of a material having a different composition do. It is found that the composition depends on the fluorine compound used during cleaning. When a fluorine-carbon compound is used, the particles contain carbon, when a fluorine-sulphur compound is used, the particles contain sulphur.

The invention has for its object *inter alia* to counteract the said disadvantages. This object is solved by the method as claimed in claim 1. Further advantageous embodiments of the method are claimed in dependent claims 2 to 5. According to the invention, the method mentioned in the opening paragraph is for this purpose characterized in that a portion of the gas mixture which is comparatively rich in oxygen is conducted into the reaction chamber through the gas inlet system with the gas inlet plate, while a portion of the gas mixture which is comparatively poor in oxygen is conducted into the reaction chamber through an auxiliary inlet system.

A plasma generated in a gas mixture comprising fluorine or a fluorine compound and oxygen or an oxygen compound has its optimum cleaning effect when a certain quantity of oxygen or oxygen compound is present in the gas mixture. In the examples given above, this was, for example, 10 to 30 vol. %, 30 to 50 vol. % or 40 to 60 vol. % oxygen or oxygen compound. Cleaning takes longer when the gas mixture comprises more or less than this optimum quantity. The oxygen in the gas mixture in addition suppresses the formation of polymers containing carbon or sulphur, and thus the deposition of particles comprising carbon or sulphur. A portion of the gas mixture comparatively rich in oxygen should herein be understood to mean a portion of the gas mixture having a composition ratio with more than the optimum quantity of oxygen or oxygen compound, while a portion comparatively poor in oxygen is a portion with a composition with less than this optimum quantity.

Since a portion of the gas mixture comparatively rich in oxygen flows through the gas inlet plate, the cleaning plasma close to the gas inlet plate is comparatively rich in oxygen. It is achieved by this that cleaning progresses less quickly near the gas inlet plate, so that an attack of the gas inlet plate is counteracted. In addition, the comparatively large quantity of oxygen in the plasma also suppresses the deposition of carbon or sulphur particles on the gas inlet plate. Such particles could arrive on the slices, as is the case in the known method described. The fact that a portion of the gas mixture poor in oxygen is introduced into the reaction chamber through a separate auxiliary inlet system achieves that on average a gas mixture of optimum composition is present between the gas inlet plate and the holder, so that the plasma has an optimum effectiveness except for the regions close to the gas inlet plate and close to the auxiliary inlet system.

Preferably, according to the invention, the portion of the gas mixture comparatively rich in oxygen is also conducted into the reaction chamber through openings in the support arranged in the reaction chamber. A slice is present on the support during deposition, so that practically no material ends up on the portion of the holder then covered by this slice. Practically no material need accordingly be removed from this surface during cleaning. When a portion of the gas mixture rich in oxygen is fed through openings in the support, it is achieved that the holder is cleaned less intensively, so that an attack by the plasma is counteracted.

This measure can be very easily realised when the support is already provided with gas ducts for other reasons. This is the case with supports provided with suction openings for fixing the slices on the support during deposition by means of vacuum, and with holders provided with gas ducts for realising a heat-conducting gas cushion between slice and support during deposition. Such supports are of an intricate construction and accordingly expensive. It is of special interest to counteract attacks by the cleaning plasma in the case of these expensive supports.

The attack on the gas inlet plate and the deposition of particles on the gas inlet plate are counteracted most strongly when the portion of the gas mixture comparatively rich in oxygen does not comprise fluorine or a fluorine compound from the gas mixture. The gas mixture conducted into the chamber through the gas inlet plate and possibly through the openings in the support then comprises only the oxygen or oxygen compound of the gas mixture, but not the fluorine or fluorine compound. The cleaning action of the plasma is then at a minimum near the gas inlet plate and possibly near the support, while also the deposition of, for example, carbon particles on these chamber components is at a minimum then.

The cleaning process can be easily implemented in practice when the portion of the gas mixture comparatively rich in oxygen also comprises all oxygen or all oxygen compound from the gas mixture. The oxygen or oxygen compound is then conducted into the reaction chamber fully separate from the fluorine or fluorine compound. As a result, the two flows may readily be adjusted completely independently of one another, whereby attacks on the gas inlet plate and deposition of undesirable particles can be prevented as well as possible, while the cleaning action of the plasma is an optimum.

The invention is explained in more detail below by way of example with reference to a drawing in which a device suitable for carrying out the method according to the invention is shown diagrammatically and in cross-section.

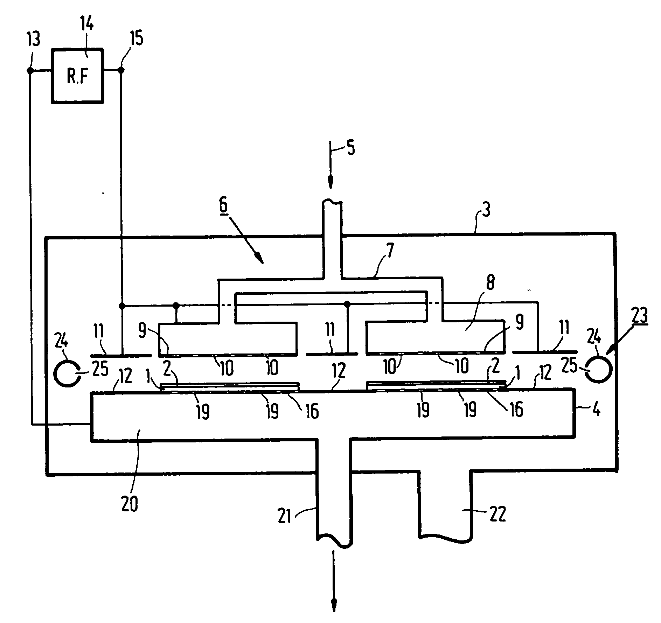

The drawing diagrammatically and in cross-section shows a device for carrying out a method for manufacturing a semiconductor device, whereby a layer of material 2 is deposited on a semiconductor slice 1 in that the slice 1 is placed on a support 4 in a reaction chamber 3. During the deposition process, diagrammatically indicated by an arrow 5, a process gas is conducted towards the slice 1 through a gas inlet system 6. During this, the slice is heated in usual manner to a temperature of 400 to 800° C in the case of a "chemical vapour deposition process". In the case of a "plasma-enhanced chemical vapour deposition process", a plasma is generated in usual manner between the support and the gas inlet plate.

The gas inlet system 6 comprises a number of tubes 7 and a gas inlet chamber 8 of which a wall forms a perforated gas inlet plate 9 arranged opposite the support 4. The gas inlet plate 9 is, for example, an aluminium plate in which a large number of holes with a diameter of, for example, 1 mm are provided, evenly distributed over its surface. The plate may also be manufactured from a porous material, such as sintered aluminium powder. Such a plate is perforated by means of channels present in the sintered material. The use of such a perforated gas inlet plate 9 achieves that the process gas 5 is homogeneously distributed over the slice 1, so that a homogeneous deposition is obtained. The gas inlet plate 9 as a diameter which is at least equally large as that of the slice and which is, for example, 15 cm.

A support 4 for a single slice 1 may be arranged in the process chamber 3, but alternatively there may be a support 4 on which several slices, such as two slices in the present example, may be placed next to one another. In the former case the chamber 3 comprises a gas inlet system 6 with a single gas inlet plate 9, in the latter case a system with several gas inlet plates 9.

A layer 2 of silicon, silicon oxide or silicon nitride, tungsten or titanium nitride, for example, is deposited on the semiconductor slice 1 during the deposition process. The process gas then comprises a gaseous silicon compund, a gas mixture with a silicon compound and oxygen or an oxygen compound, a gas mixture with a silicon compound and nitrogen or a nitrogen compound, a tungsten compound, or a titanium compound, respectively, in these cases. Usual silicon compounds are silane, dichlorosilane, and tetraethoxysilane, a usual oxygen compound is laughing gass, and a usual nitrogen compound is ammonia.

A layer of material 2 is deposited not only on the slice 1 during the deposition process, but also on chamber components situated in the vicinity of the slice. These are, for example, screens 11 positioned around the gas inlet plates and the portion 12 of the support 4 not covered by slices 1. When the deposition process is repeated, layers being deposited on other slices, the layer on these chamber components increases in thickness. When the layer on the chamber components becomes too thick, particles may flake off from this layer, and end up on the slice. These particles are undesirable there. Accordingly, the reaction chamber 3 is cleaned periodically in that a plasma is generated between the support 4 and the gas inlet plate 9 in a gas mixture comprising fluorine or a fluorine compound and oxygen or an oxygen compound. The support 4 is for this purpose connected to one of the poles 13 of a usual HF generator 14 operating at 13,5 MHz, while the gas inlet plates 9 and the screens 11 are connected to the other pole 15 of this generator 14.

Practical gas mixtures for this cleaning are, for example, a mixture of CF₄ and O₂, a mixture of SF₆ and N₂O, or a mixture of C₂F₆ and O₂, which have a maximum cleaning action when 10 to 30 vol.%, 30 to 50 vol.% or 40 to 60 vol.% O₂, respectively, are added thereto. The materials mentioned above such as silicon, silicon oxide, and silicon nitride can be very effectively removed by means of such plasmas. The support in this example is provided with a contact plate 16 on which the slices 1 can be placed and which is provided with suction openings 19. The support further comprises a vacuum chamber 20 which is connected to a vacuum pump (not shown) through a line 21. During the deposition the vacuum chamber 20 is then brought to a low pressure, so that the slices 1 are retained on the support through the openings 19 by vacuum.

Residual gases, such as unused reaction gases and gases evolved during the deposition are removed from the reaction chamber 3 through a suction opening 22.

During cleaning of the reaction chamber 3, according to the invention, a portion of the gas mixture comparatively rich in oxygen is conducted into the reaction chamber through the gas inlet system 5 comprising the gas inlet plate 9, while a portion of the gas mixture comparatively poor in oxygen is conducted into the reaction chamber through an auxiliary inlet system 23. The auxiliary inlet system in this example comprises a tube 24 surrounding the support 4 and provided with gas outlet openings 25. The gas used for cleaning should then be fed into the tube 24 through a line which is not shown in the drawing.

The plasma generated in a gas mixture comprising fluorine or a fluorine compound and oxygen or an oxygen compound has its optimum cleaning effect when a certain quantity of oxygen or oxygen compound is present in the gas mixture. In the examples given above, for example, this was 10 to 30 vol. %, 30 to 50 vol. % or 40 to 60 vol. % oxygen or oxygen compound. Cleaning takes longer when the gas mixture contains more or less than this optimum quantity. A portion of the gas mixture comparatively rich in oxygen is a portion of the gas mixture having a composition ratio with more than the optimum quantity of oxygen or oxygen compound, while a portion comparatively poor in oxygen is a portion containing less than this optimum quantity. A good cleaning was obtained in that a gas mixture of 600 scc C₂F₆ and 1200 scc O₂ per minute was fed through the gas inlet plate 9, and a gas mixture of 1200 scc C₂F₆ and 600 scc O₂ per minute through the tube 24.

Since a portion of the gas mixture comparatively rich in oxygen flows through the gas inlet plate, the cleaning plasma close to the gas inlet plate 9 is comparatively rich in oxygen. It is achieved by this that cleaning progresses less quickly near the gas inlet plate 9, so that attacks on the gas inlet plate 9 are counteracted. The comparatively large quantity of oxygen in the plasma in addition suppresses the deposition of carbon or sulphur particles on the gas inlet plate 9. Such particles could end up on the slices 1. The conduction of a portion of the gas mixture poor in oxygen through the auxiliary inlet system 23 into the reaction chamber 3 achieves that on average nevertheless a gas mixture of optimum composition is present between the gas inlet plates 9 and the support 4, so that the plasma has an optimum effectiveness except for the regions close to the gas inlet plates 9 and close to the auxiliary inlet system 23.

Preferably, according to the invention, the portion of the gas mixture comparatively rich in oxygen is also conducted into the reaction chamber 3 through openings 19 in the support 4 arranged in the reaction chamber 3. Slices 1 are present on the support 4 during deposition, so that practically no material is deposited on the portion of the support 4 covered by these slices then. So practically no material is to be removed from this surface during cleaning. When a portion of the gas mixture rich in oxygen is fed through the openings 19, it is also achieved that the support is cleaned less thoroughly, so that attacks by the plasma are conteracted. A good cleaning action with substantially no attack on the gas inlet plate 9 and the support 4 is obtained when a gas mixture of 300 scc C₂F₆ and 600 scc O₂ is fed through the gas inlet plate 9 and through the support 4, while a gas mixture of 1200 scc C₂F₆ and 600 scc O₂ is fed through the tube 24.

The attack of the gas inlet plate 9 and the deposition of particles on the gas inlet plate 9 are counteracted most strongly when the portion of the gas mixture comparatively rich in oxygen contains no fluorine or fluorine compound from the gas mixture. The gas mixture fed through the gas inlet plate 9 and possibly through the openings 19 in the support 4 into the chamber 3 then contains only the oxygen or the oxygen compound of the gas mixture, but not the fluorine or the fluorine compound. The cleaning action of the plasma is then at a minimum near the gas inlet plate 9 and possibly near the support 4, while also the deposition of, for example, carbon particles on the chamber components 10, 11 and 12 is at a minimum then. In practice, for example, 600 scc O₂ per minute is then fed through the gas inlet plate 9, 600 scc O₂ through the support 4, and a gas mixture of 600 scc O₂ and 1800 scc C₂F₆ through the ring 24.

The cleaning process can be readily implemented in practice when the portion of the gas mixture comparatively rich in oxygen also comprises all oxygen or all oxygen compound. The oxygen or oxygen compound is then fed into the reaction chamber completely separate from the fluorine or fluorine compound. As a result, the two flows may be easily adjusted fully independently of one another, so that attacks on the gas inlet plate and deposition of undesirable particles can be prevented as well as possible, while the cleaning action of the plasma is an optimum. In practice, for example, 900 scc O₂ per minute is fed through the gas inlet plate 9, 900 scc O₂ through the support 4, and 1800 scc C₂F₆ through the ring 24.

## Claims

1. A method of manufacturing a semiconductor device whereby a reaction chamber in which a layer of material is deposited on a semiconductor slice placed on a support in the reaction chamber, whereby a process gas is conducted towards the slice through a gas inlet system which is provided with a perforated gas inlet plate arranged opposite the support, between depositions is cleaned periodically through the generation of a plasma between the support and the gas inlet plate in a gas mixture comprising fluorine or a fluorine compound and oxygen or an oxygen compound, characterized in that a portion of the gas mixture which is comparatively rich in oxygen is conducted into the reaction chamber through the gas inlet system with the gas inlet plate, while a portion of the gas mixture which is comparatively poor in oxygen is conducted into the reaction chamber through an auxiliary inlet system.

2. A method as claimed in Claim 1, characterized in that the portion of the gas mixture comparatively rich in oxygen is also conducted into the reaction chamber through openings in the support arranged in the reaction chamber.

3. A method as claimed in Claim 1 or 2, characterized in that the portion of the gas mixture comparatively rich in oxygen does not comprise fluorine or a fluorine compound from the gas mixture.

4. A method as claimed in Claim 3, characterized in that the portion of the gas mixture comparatively rich in oxygen also comprises all oxygen or all oxygen compound from the gas mixture.

5. A method as claimed in any one of the preceding Claims, characterized in that the auxiliary inlet system comprises a tube surrounding the support and provided with gas outlet openings.

## Patentansprüche

1. Verfahren zum Herstellen einer Halbleiteranordnung, wobei eine Reaktionskammer, in der eine Materialschicht auf einer auf einem Halter in der Reaktionskammer plazierten Halbleiterscheibe abgeschieden wird, wofür ein Prozeßgas durch ein Gaseinlaßsystem, das mit einer gegenüber dem Halter angeordneten perforierten Gaseinlaßplatte versehen ist, zu der Scheibe geleitet wird, zwischen Abscheidungen periodisch gereinigt wird, indem zwischen dem Halter und der Gaseinlaßplatte in einer Fluor oder eine Fluorverbindung und Sauerstoff oder eine Sauerstoffverbindung enthaltenden Gasmischung ein Plasma erzeugt wird, dadurch gekennzeichnet, daß ein verhältnismäßig sauerstoffreicher Anteil der Gasmischung durch das Gaseinlaßsystem mit der Gaseinlaßplatte in die Reaktionskammer geleitet wird, während ein verhältnismäßig sauerstoffarmer Anteil der Gasmischung durch ein Hilfseinlaßsystem in die Reaktionskammer geleitet wird.

2. Verfahren nach Anspruch 1, dadurch gekennzeichnet, daß der verhältnismäßig sauerstoffreiche Anteil der Gasmischung auch durch Öffnungen in dem in der Reaktionskammer angeordneten Halter in die Reaktionskammer geleitet wird.

3. Verfahren nach Anspruch 1 oder 2, dadurch gekennzeichnet, daß der verhältnismäßig sauerstoffreiche Anteil der Gasmischung weder Fluor noch eine Fluorverbindung aus der Gasmischung umfaßt.

4. Verfahren nach Anspruch 3, dadurch gekennzeichnet, daß der verhältnismäßig sauerstoffreiche Anteil der Gasmischung auch allen Sauerstoff oder alle Sauerstoffverbindungen aus der Gasmischung umfaßt.

5. Verfahren nach einem der vorhergehenden Ansprüche, dadurch gekennzeichnet, daß das Hilfseinlaßsystem ein den Halter umgebendes und mit Gasauslaßöffnungen versehenes Rohr umfaßt.

## Revendications

1. Procédé pour fabriquer un dispositif semi-conducteur, suivant lequel une chambre à réaction dans laquelle une couche de matériau est déposée sur une tranche semi-conductrice placée sur un support disposé dans la chambre à réaction est nettoyée périodiquement entre des dépôts par l'engendrement d'un plasma entre le support et la plaque d'admission de gaz dans un mélange de gaz constitué de fluor ou d'un composé de fluor et d'oxygène ou d'un composé d'oxygène, et suivant lequel un gaz de processus est amené vers la tranche par l'intermédiaire du système d'admission de gaz muni d'une plaque d'admission de gaz perforée disposée à l'opposé du support, caractérisé en ce qu'une partie du mélange de gaz qui est relativement riche en oxygène est amenée dans la chambre à réaction par l'intermédiaire du système d'admission de gaz présentant la plaque d'admission de gaz, alors qu'une partie du mélange de gaz qui est relativement pauvre en oxygène est amenée dans la chambre à réaction par l'intermédiaire d'un système d'admission auxiliaire.

2. Procédé selon la revendication 1, caractérisé en ce que la partie du mélange de gaz relativement riche en oxygène est également amenée dans la chambre à réaction à travers des ouvertures percées dans le support disposé dans la chambre à réaction.

3. Procédé selon la revendication 1 ou 2, caractérisé en ce que la partie du mélange de gaz relativement riche en oxygène ne contient aucun fluor ou aucun composé de fluor provenant du mélange de gaz.

4. Procédé selon la revendication 3, caractérisé en ce que la partie du mélange de gaz relativement riche en oxygène comporte également tout l'oxygène ou tout le composé d'oxygène provenant du mélange de gaz.

5. Procédé selon l'une quelconque des revendications précédentes, caractérisé en ce que le système d'admission auxiliaire comporte un tube entourant le support et percé d'ouvertures de sortie de gaz.
